# EUROPEAN PATENT SPECIFICATION

(11) **EP 4 068 534 B1**
(45) Date of publication and mention of the grant of the patent: **05.03.2025**
(21) Application number: 22305409.9
(22) Date of filing: 31.03.2022
(51) Int. Cl.: H01S 5/026, H01S 5/042, H01S 5/40, G01S 7/481, G01S 7/484

(54) **IMPROVED ELECTRONIC DEVICE FOR LIDAR APPLICATIONS**
VERBESSERTE ELEKTRONISCHE VORRICHTUNG FÜR LIDARANWENDUNGEN
DISPOSITIF ÉLECTRONIQUE AMÉLIORÉ POUR DES APPLICATIONS DE LIDAR

(30) Priority: 31.03.2021 IT 202100008057
(43) Date of publication of application: 05.10.2022
(73) Proprietor: STMicroelectronics S.r.l., 20864 Agrate Brianza (MB) (IT); STMicroelectronics (Rousset) SAS, 13790 Rousset (FR)
(72) Inventor: PIZZARDI, Antonio Filippo Massimo, 95045 MISTERBIANCO (IT); SMERZI, Santo Alessandro, 95127 CATANIA (IT); IUCOLANO, Ferdinando, 95030 GRAVINA DI CATANIA (IT); LETOR, Romeo, 95030 MASCALUCIA (IT)
(74) Representative: Studio Torta S.p.A.

(56) References cited:
- WO-A1-2020/162128
- US-A1- 2018 278 011
- US-A1- 2018 278 017
- US-A1- 2019 386 460
- US-B1- 6 246 708

## Description

The present invention relates to an improved electronic device for LIDAR applications. In particular, it relates to an electronic device comprising, or couplable to, a plurality of laser diodes, for biasing them. The electronic device presents reduced parasitic inductances. In addition, the present invention relates to a laser-driving module comprising the electronic device, to a lighting module comprising the driving module and the laser diodes, and to a LIDAR apparatus comprising the laser lighting module.

Thanks to their 3D sensing capacity and to the ability to function in the dark and in unfavourable meteorological conditions, LIDAR (LIght Detection And Ranging or Laser Imaging Detection And Ranging) systems are increasingly used, in possible combination with video cameras and radar systems, for environmental mapping and for other safety applications, such as emergency braking, detection of pedestrians and collision avoidance in the automotive sector.

Very short high-current pulses (such as current pulses that have an intensity in the range of tens of amps with rise and fall times in the (sub)nanosecond time range, for example, of the order of 100 ps) are desirable for laser diodes for LIDAR systems used for measuring the distances with the use time-of-flight (ToF) measurements techniques with medium-to-short distance values (e.g., distances of less than approximately 100 m with resolutions of measurement of ±15 cm).

Arrays of laser diodes comprising laser diodes activated in sequence or in parallel are also used for improving the signal-to-noise (S/N) ratio in the return signal received. Multi-channel drivers afford the possibility of selecting the diode (diodes) to be activated with a short current pulse of high intensity.

However, existing LIDAR systems present non-negligible parasitic inductances (e.g., higher than 1 nH), in particular on account of the use of the arrays of laser diodes, which cause degraded electrical performance of the latter.

Minimization of the parasitic inductances represents a challenge in the design of a driver for laser diodes.

For instance, the most common solutions of implementation of LIDAR systems envisage assembly of one or more laser diodes directly on a printed-circuit board (PCB) by soldering of one of its anode or cathode terminals to the PCB and connection of the other anode or cathode terminal by wire bonding. The disadvantage of this solution lies in the fact that the inductance deriving from the connection by wire bonding presents a value in the order of 1 nH, which is high for applications in which, as discussed above, a precise control of the duration of the pulses of the laser diodes is important.

In addition, often laser diodes are sold separately from the PCB and are assembled on the latter only by an end user/customer. In this case, the laser diodes are supplied by the manufacturers, for example on strips of plastic material; the laser diodes are bonded to said strips and arranged with respect to one another in an array thereon, and are therefore set at standardized relative distances from one another, which cannot be modified except by using personalized strips of laser diodes, which, however, present costs that are decidedly higher than standardized strips of laser diodes that are commonly available on the market.

Document EP3937317, of the same Applicant, relates to pulse generator circuits.

US2018/278011 discloses an electronic device with a driver coupled to an array 20 of laser diodes 20a, 20b, 20c, 20d. Driver IC4 comprises a semiconductor body having a first upper surface and including four switches 40a, 40b, 40c, 40d.

The aim of the present invention is to provide an improved electronic device for LIDAR applications, a laser-driving module, a laser lighting module and a LIDAR apparatus that will overcome the drawbacks of the prior art.

According to the present invention an improved electronic device for LIDAR applications, a laser-driving module, a laser lighting module and a LIDAR apparatus are provided as defined in the annexed claims.

For a better understanding of the present invention, a preferred embodiment will now be described, purely by way of non-limiting example, with reference to the attached drawings, wherein:
- Figure 1 is a block diagram of a laser lighting module for a LIDAR apparatus, according to an embodiment of the present invention;
- Figure 2 is a general representation of the laser lighting module of Figure 1;
- Figure 3 illustrates an electronic device of the LIDAR system, comprised in the laser lighting module of Figure 1, and moreover presents an enlarged view of a detail of the electronic device, according to an embodiment of the present invention;
- Figures 4A-4D illustrate respective views of a portion of the electronic device of Figure 3 with parts removed; and
- Figure 5 illustrates a possible architecture of a LIDAR apparatus for the automotive sector, according to an example of embodiment of the present invention.

Elements in common to the various embodiments of the present invention, described in what follows, are designated by the same reference numbers.

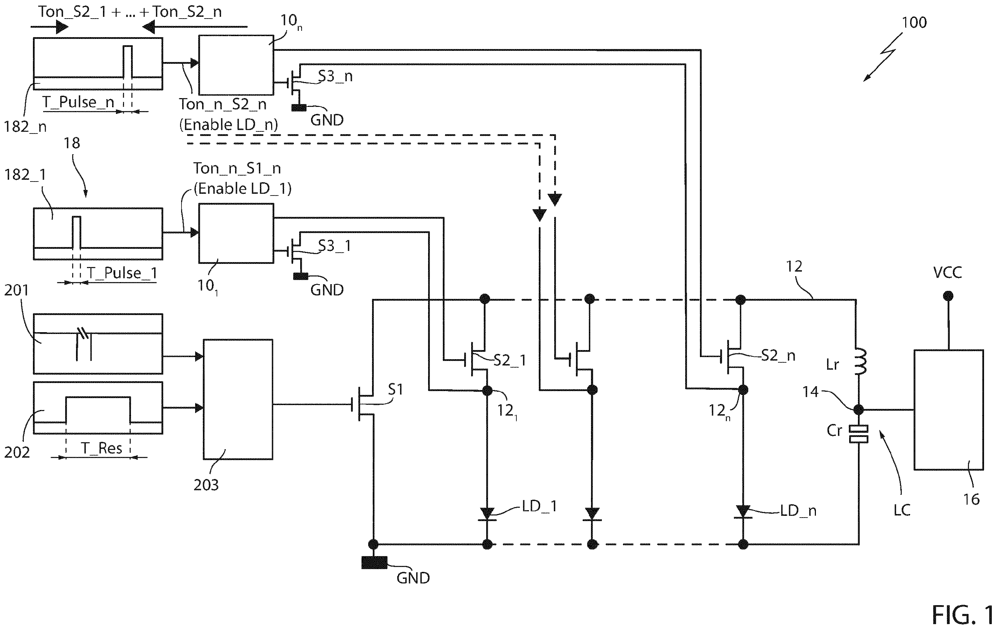

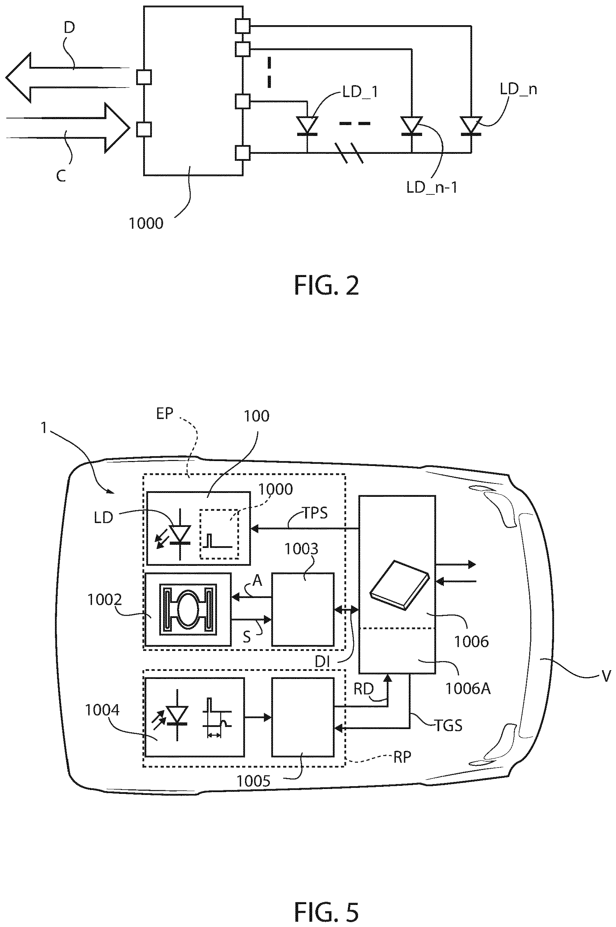

Figure 1 shows a laser lighting module 100 comprised in a LIDAR apparatus 1 (illustrated in Figure 5), according to an embodiment of the present invention.

The laser lighting module 100 is formed by a laser-driving module and a plurality of laser diodes. For instance, in Figure 1 four laser diodes are present, which are arranged in an array and are designated by the reference symbols LD_1, LD_2, ..., LD_n, where n (n = 2, 3 ...) is the number of laser diodes that form the array. By way of non-limiting example, n=4.

The laser diodes LD_1, LD_2, ..., LD_n are configured to be activated selectively (in a pulsed way) by respective half-bridges S2_1, S3_1 (for the laser diode LD_1), ..., S2_n, S3_n (for the laser diode LD_n).

The half-bridges S2_1, S3_1, ..., S2_n, S3_n comprise electronic switches such as field-effect transistors and, for example, HEMT (High Electron Mobility Transistor) devices and/or MOSFETs. In detail, each half-bridge S2_1, S3_1, ..., S2_n, S3_n comprises: a respective first switch S2_1, .. S2_n coupled between a first node or line 12 (common to all the half-bridges S2_1, S3_1, ..., S2_n, S3_n) and a respective second driving node 12₁,..., 12ₙ; and, optionally, a respective second switch S3_1,.. S3_n coupled between the respective second driving node 12₁,..., 12ₙ and a reference line or node (e.g., ground GND, referred to in what follows as reference node GND) common to all the half-bridges S2_1, S3_1, ..., S2_n, S3_n.

The cathodes (designated in what follows by the reference number LDc_1, ..., LDc_n) of the laser diodes LD_1, ..., LD_n are coupled to the reference node GND, and the anodes (designated in what follows by the reference number LDa_1, ..., LDa_n) of the laser diodes LD_1, ..., LD_n are coupled to the second driving nodes 12₁,..., 12ₙ of the respective half-bridges S2_1, S3_1, ..., S2_n, S3_n. Consequently, the laser diodes LD_1, ..., LD_n are arranged in a common-cathode configuration.

The half-bridges S2_1, S3_1, ..., S2_n, S3_n are driven by respective driving circuits 10₁, ..., 10ₙ coupled to the control terminals (the gates, in the case considered herein by way of example) of the switches of the half-bridges S2_1, S3_1, ..., S2_n, S3_n.

In the following, in order to avoid rendering the ensuing description excessively complicated, a notation such as S2_j, S3_j and LD_j, 10j, 12j and the like will be used (where j= 1, ..., n).

Coupled between the first node or line 12 and the reference node GND a resonant tank (or circuit) LC is present comprising an inductor Lr and a capacitor Cr connected in series. As illustrated, the inductor Lr is arranged in an intermediate position between the first node or line 12 and an intermediate node 14 of the resonant tank circuit LC, and the capacitor Cr is arranged in an intermediate position between the intermediate node 14 and the reference node GND.

The intermediate node 14 is coupled to a charge circuit (also referred to in what follows as regulator) 16, of a known type, which receives a supply voltage VCC.

A control switch S1, such as a GaN (gallium-nitride) field-effect transistor (for example, a GaN HEMT), is coupled in an intermediate position between the first node or line 12 and the reference node GND.

The control switch S1 and the switches S2_j, S3_j are driven as a function of enable signals supplied, as discussed hereinafter, by a control circuitry designated as a whole by 18 and comprising the driving circuits 10ⱼ. Purely for simplicity of description and understanding, it may be considered that the control circuitry 18 comprises: the driving circuits 10₁, ..., 10ₙ; respective control circuits 182_1, .., 182_n (182_j) for the half-bridges S2_1, S3_1, ..., S2_n, S3_n, configured to send to the half-bridges S2_1, S3_1, ..., S2_n, S3_n respective enable signals Ton_S2_1, ..., Ton_S2_n (Ton_S2_j) to enable supply of energy to (and therefore emission of light from) the respective laser diode LD_1, .., LD_n; and two further control circuits 201, 202 configured to control, by an AND logic gate 203, the first switch S1 (e.g., by its control electrode, a gate in the case of a field-effect transistor). As has been mentioned, the control circuits 182_j, 201, 202 and 203 are represented as distinct entities purely for simplicity of description and understanding. In fact, according to a different aspect of the present invention, these control circuits are integrated in a single control unit 18.

As described more fully in what follows, the control circuitry 18 enables co-ordination of operation of the control switch S1 with operation of the first switches S2_j and of the second switches S3_j in order to obtain generation of (ultra)short pulses (in the order of the (sub)nanosecond time range and, for example, in the order of 100 ps), with high di/dt (e.g., higher than approximately 80 nA/ns), which are switched on the laser diodes LD_j to obtain individual activation and selective emission of light.

In particular, the control switch S1 supplies energy to the resonant tank LC, thus defining the energy content and the peak current of the pulses of the laser diode LDj to be activated.

Each first switch S2_j, the respective second switch S3_j, and the respective laser diode LD_j form a j-th light-emission channel that can be activated by the respective driving circuit 10j. The first switch S1 is therefore connected in parallel and common to all the light-emission channels, as well as to the resonant tank LC.

The regulator 16 can be implemented in a per se known manner so as to charge the capacitor Cr in the resonant tank LC to a voltage adequate for obtaining a peak current in the resonant tank LC equal to or higher than a desired pulse current of the laser diode LD_j.

According to an aspect of the present invention, the control switch S1 and the first switches S2_j are GaN transistors designed to function at high power (e.g., higher than approximately 100 W). This facilitates a monolithic solution, for example with existing GaN technology. Instead, the second switches S3_j are conventional silicon-based transistors and are designed to function at low powers (e.g., signal HEMTs or MOSFETs). Optionally, the second switches S3_j can be integrated in the respective driving circuits 10j in so far as they absorb very low currents, namely, the parasitic currents that flow in the output capacitance of the respective first switches S2_j. For instance, the second switches S3_j have propagation delays comprised between approximately 2 ns and approximately 3 ns, rise and fall times comprised between approximately 300 ps and approximately 500 ps, and peak source currents and sink currents comprised between approximately 5 A and approximately 7 A in order to speed up charging of input capacitances of the control switch S1 and of the first switches S2_j.

In greater detail, in the design stage, the control switch S1 is sized as a function of the value of the RMS current and the peak current in the resonant tank LC, and the first switches S2_j are sized as a function of the value of the RMS current and the peak current in the laser diodes LD_j, as described more fully hereinafter.

There now follows a description of a method of use of the laser lighting module 100.

In particular, the first and second switches S2_j and S3_j are driven by the control circuitry 18 in half-bridge configuration so that: when the first switch S2_j is on (i.e., conductive), the second switch S3_j is off (open and non-conductive), and the laser diode LD_j can be activated by injecting current in the latter through the respective light-emission channel; and, when the first switch S2_j is off, the second switch S3_j is on (closed and conductive), thus coupling the respective driving node 12ⱼ to the reference node GND and thus countering undesired spurious currents that flow through the laser diode LD_j.

In greater detail, when the control switch S1 is off, the capacitor Cr is charged, by the regulator 16, to a voltage value (e.g., comprised between approximately 10 V and approximately 20 V), which is adequate for obtaining a desired current in the resonant tank LC (e.g., comprised between approximately 20 A and approximately 60 A).

When the control switch S1 is switched to the on state (closed and rendered conductive), the resonant tank LC starts to oscillate and the current increases in the inductor Lr.

In response to the fact that the current of the resonant tank LC reaches a threshold, the control switch S1 is switched to the off state (open and rendered non-conductive) for a time corresponding to the pulse length (pulse duration) of the laser diode LD_j (for example, 1 ns). In addition, one of the first switches S2_j, the one corresponding to the laser diode LD_j that is to be activated, is switched to the on state (closed or rendered conductive) for said pulse duration, in response to an enable signal for enabling the laser diode LD_j emitted by the respective control circuit 182_j.

During the time of the pulse duration, the inductor Lr behaves substantially like a current source and a current that flows in the laser diode LD_j activated by the first switch S2_j brought to the on (conductive) state.

When the pulse duration expires, the first switch S2_j is switched to the off state (i.e., rendered non-conductive).

Another laser diode LD_j (or even the same laser diode LD_j) can be activated during a same pulse produced by the resonant circuit LC by a sub-sequence comprising: switching the first switch S2_j to the on state (rendering it conductive) for the pulse duration; switching the control switch S1 to the off state (non-conductive) for the pulse duration; and switching the first switch S2_j to the off state (non-conductive) when the pulse duration expires. Such a sub-sequence can be repeated a certain number of times with the control switch S1 that remains on (conductive) until the resonance period of the resonant tank LC expires, compatibly with gradual discharging of the resonant tank LC.

When such a time is reached, at a zero-crossing current, the control switch S1 can be switched to the off state, and the voltage on the capacitor Cr will rise once again towards a value defined by the residual energy of the resonant tank LC.

Figure 2 shows an integrated device or circuit (IC), such as a System on Package, referred to in what follows as electronic device 1000.

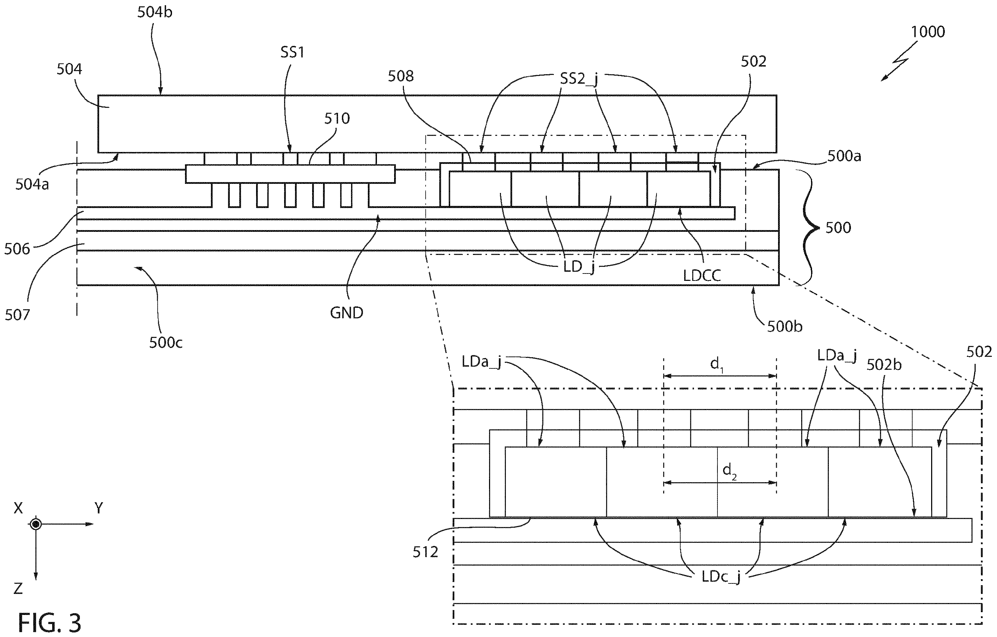

The electronic device 1000 is an integrated circuit that is comprised in the laser lighting module 100 and that, in particular, comprises the control GaN switch S1 and the second GaN switches S2_j. The electronic device 1000 enables driving of the laser diodes LD_j with short pulses (in the nanosecond range) at a high current, for LIDAR applications, as discussed more fully hereinafter. The structure of the electronic device 1000 is described in greater detail in the following with reference to Figure 3.

According to an embodiment of the present invention (illustrated in Figure 2), the laser diodes LD_j are elements distinct from the electronic device 1000 (i.e., not integrated therein), and it is envisaged that they are coupled to the electronic device 1000 only by an end user/customer.

Optionally, the electronic device 1000 can provide additional functions for control of the current and of the timing of the pulses (denoted as a whole by C) and for diagnostics (denoted by D), of a per se known type. It should be noted that such a configuration is not in itself dedicated to a multi-channel driver for a laser array, and that a single-channel configuration comprising a single laser diode LD_1 can also be used.

Figure 3 shows, by way of example, the electronic device 1000 for the four-channel driving laser, comprising said transistors (in particular, GaN HEMTs) integrated therein.

In particular, the electronic device 1000 is illustrated, in a triaxial cartesian reference system defined by the axes X, Y, and Z, in cross-sectional view along a plane YZ defined by the axes Y and Z.

According to one embodiment, the electronic device 1000 comprises a solid body 500 having a first surface 500a and a second surface 500b opposite to one another along the axis Z.

According to an embodiment of the present invention, exemplified in what follows, the solid body 500 is formed by a first semiconductor body of semiconductor material, in particular GaN.

A cavity 502 extends in the solid body 500 and faces the first surface 500a.

The laser diodes LD_j are housed in the cavity 502 by the end user/customer. In what follows, for simplicity of description, reference is made by way of example to the case where the laser diodes LD_j are already inserted in the electronic device 1000. In detail, each laser diode LD_j has its respective cathode LDc_j facing a bottom wall 502b of the cavity 502, as discussed more fully hereinafter.

In greater detail, the cavity 502 moreover faces a lateral surface 500c of the solid body 500, which joins together the first and second surfaces 500a and 500b. Furthermore, the laser diodes LD_j are edge-emitting lasers, and are arranged in the cavity 502 so as to have the respective radiation-emitting surfaces facing towards the lateral surface 500c, and therefore towards the outside of the cavity 502 and of the electronic device 1000. In other words, the radiation generated by the laser diodes LD_j is emitted in a direction substantially orthogonal to the lateral surface 500c, towards the outside of the electronic device 1000.

In addition, for example, the solid body 500 integrates, or is electrically coupled (e.g., by soldering) to, the control circuitry 18, the second switches S3_j, the resonant tank LC and the regulator 16.

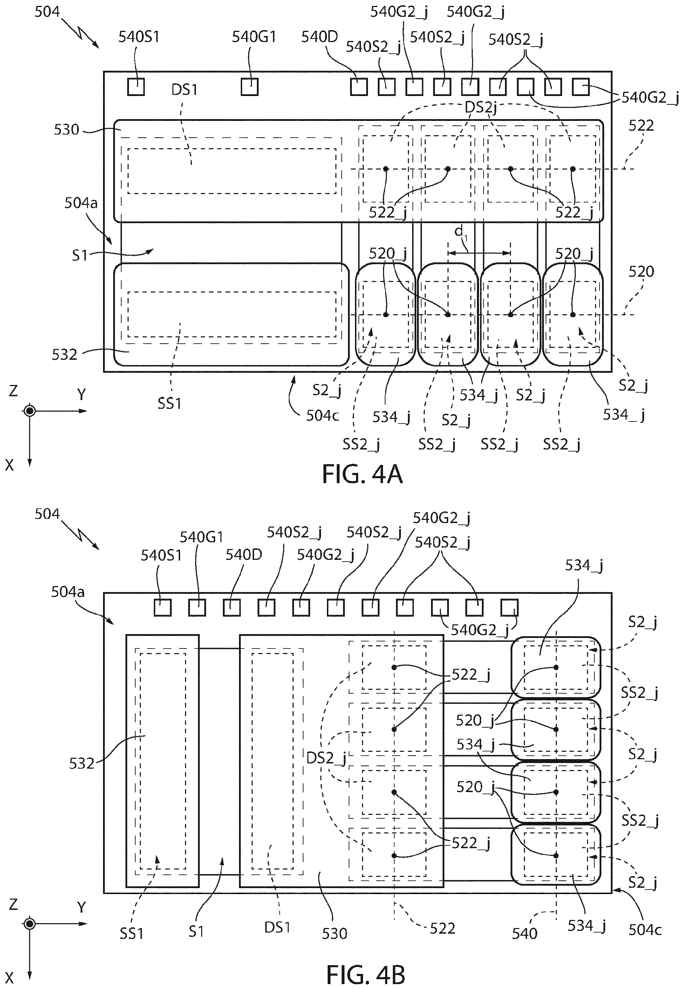

The electronic device 1000 further comprises a second semiconductor body 504 (of semiconductor material, such as GaN). In detail, the second semiconductor body 504 is physically and electrically coupled (e.g., fixed, for example by wafer-bonding and/or gluing techniques) to the solid body 500 and has a respective first surface 504a and a respective second surface 504b opposite to one another along the axis Z. In particular, the first surfaces 500a and 504a of the solid body 500 and of the second semiconductor body 504 face one another. The second semiconductor body 504 comprises, as discussed more fully with reference to Figures 4A and 4B, the control switch S1 and the first switches S2_j, which face the first surface 504a of the second semiconductor body 504.

In Figure 4A, the source of the control switch S1 is designated by the reference SS1, and the sources of the first switches S2_j are designated by SS2_j. The sources SS2_j of the first switches S2_j are electrically connected to the anodes LDa_j of the respective laser diodes LD_j by respective second source metallizations 534_j of the electronic device 1000 (Figures 4A-4D, as discussed more fully in what follows; the second source metallizations 534_j are placed, i.e. extend, on the first surface 504a of the second semiconductor body 504) and first conductive vias 508 (for example, of a metal such as copper or gold, which extend in a direction orthogonal to the first surface 504a of the second semiconductor body 504). The source SS1 of the control switch S1 is electrically connected, by a first source metallization 532 of the electronic device 1000 (Figures 4A-4D, as discussed more fully in what follows; the first source metallization 532 is placed, i.e. extend, on the first surface 504a of the second semiconductor body 504) and second conductive vias 510 (e.g., of copper or gold), to a reference conductive layer 506 (hereinafter referred to as layer GND 506, and for example of metal material, such as gold or copper), which extends in the solid body 500. The cathodes LDc_j of the laser diodes LD_j are also electrically connected to the layer GND 506, for example by an electrode or third conductive vias 512 (e.g., of copper or gold), which operate as common cathode of the laser diodes LD_j (here designated by LDCC) . Consequently, the layer GND 506 operates as said reference node GND. For instance, the first conductive vias 508 have a maximum length, not illustrated and measured along the axis Z, of less than approximately 500 µm and, for example, comprised between approximately 300 µm and approximately 500 µm.

According to the present invention, the second source metallizations (534_j) are aligned with one another in a first direction of alignment 520 and overlie, in a direction orthogonal to the first direction of alignment 520, the respective sources SS2_j of the first switches S2_j. Moreover, each second source metallization 534_j is, at least partially, physically aligned (along the axis Z, and therefore in a direction orthogonal to the first direction of alignment 520) to the respective laser diode LD_j, to which it is electrically connected. In particular, each second source metallization 534_j faces the cavity 502 and is, in more detail, vertically aligned with the anode LDa_j of the respective laser diode LD_j.

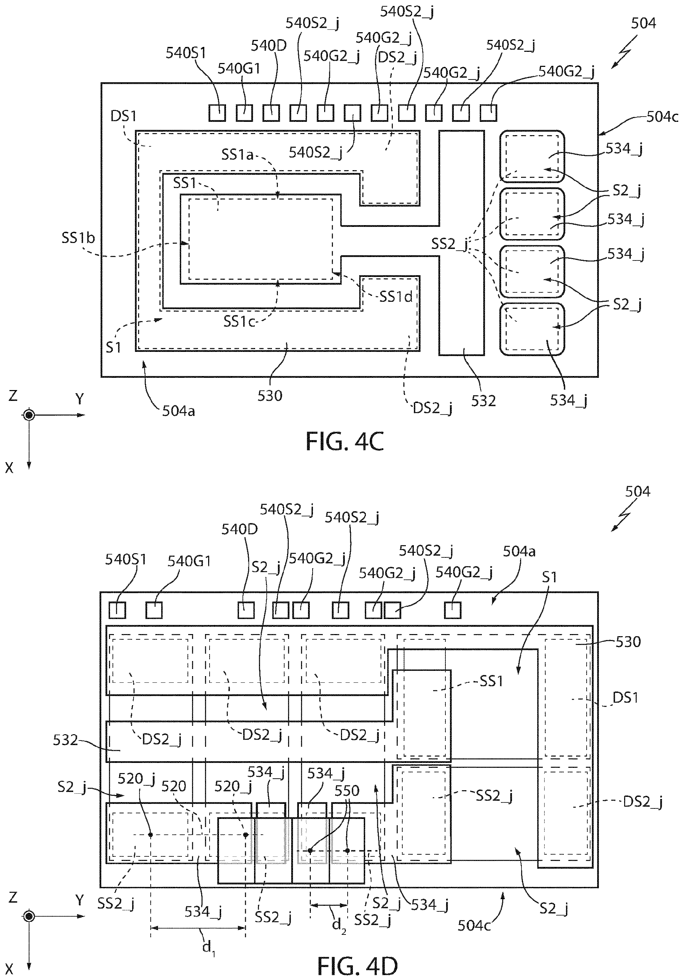

Furthermore, according to the present invention, at least one of the sources SS2_j of the first switches S2_j is aligned, in a direction orthogonal to the direction of alignment 520, to the respective laser diode LD_j (in other words, it is physically set on top, along the axis Z, of the respective laser diode LD_j). In particular, at least one of the sources SS2_j of the first switches S2_j is vertically aligned with the anode LDa_j of the respective laser diode LD_j. As discussed more fully in what follows, Figures 3-4C show embodiments in which each of the sources SS2_j of the first switches S2_j is physically set on top (along the axis Z) of the respective laser diode LD_j, whereas Figure 4D shows an embodiment in which only some of the sources SS2_j of the first switches S2_j are physically set on top (along the axis Z) of the respective laser diodes LD_j.

Considering by way of example the embodiments of Figures 3-4C, a centroid (520_j in Figure 4A) of the source SS2_j of each first switch S2_j, calculated in the plane XY and therefore in a direction parallel to the first surface 504a of the second semiconductor body 504 and/or to the first surface 500a of the solid body 500, is substantially set on top, along the axis Z, of a centroid (designated in Figure 4D by the reference number 550) of the anode LDa_j of the respective laser diode LD_j, calculated in the plane XY. In greater detail, the centroids 520_j of the sources SS2_j of the first switches S2_j close to one another (i.e., immediately consecutive to one another in the array of switches) have a maximum relative distance d₁ from one another that is equal to a maximum relative distance d₂ between the centroids 550 of the anodes LDa_j of the respective laser diodes LD_j (i.e., of the laser diodes LD_j connected to the first switches S2_j considered, and therefore also immediately consecutive to one another in the array of laser diodes). By way of non-limiting example, the maximum relative distances d₁ and d₂ are comprised between approximately 200 µm and approximately 500 µm and, more in general, are less than 500 µm. Optionally, the sources SS2_j of the first switches S2_j close to one another are at a distance apart of approximately 10 µm.

Furthermore, optionally, the first switches S2_j have an area of extension, in a plane XY defined by the axes X and Y, that is designed on the basis of the RMS currents and/or the peak current that are to flow in the respective laser diodes LD_j. For instance, the area of extension of each first switch S2_j is such that a density of RMS current generated thereby is comprised between approximately 30 A/mm² and approximately 40 A/mm² (values measured at approximately 25°C) and, optionally, the respective on-state resistance R_{DSon} is comprised between approximately 15 mΩ and approximately 30 mΩ.

Figure 4A shows, in the plane XY, a layout of the second semiconductor body 504 (in particular, of the first surface 504a of the second semiconductor body 504), according to one embodiment. By way of example, some parts of the semiconductor body 504 have been removed and will not be discussed in what follows (e.g., gate terminals and metallizations, possible passivation layers, etc.).

Figure 4A shows the control switch S1 and the first switches S2_j provided in the second semiconductor body 504, at the first surface 504a of the second semiconductor body 504. In detail, in Figure 4A the drain of the control switch S1 is denoted by the reference DS1, and the drains of the first switches S2_j are denoted by DS2_j.

The control switch S1 and the first switches S2_j are arranged to form an array along the axis Y. In particular, the sources SS2_j of the first switches S2_j (and, optionally, also the source SS1 of the control switch S1) are aligned with one another in the first direction of alignment 520 parallel to the axis Y, and the drains DS2_j of the first switches S2_j (and, optionally, also the drain DS1 of the control switch S1) are aligned with one another in a second direction of alignment 522 parallel to the axis Y. For instance, the first and second directions of alignment 520 and 522 join the centroids (designated in Figure 4A by the reference numbers 520_j and 522_j, respectively) in the plane XY of the sources SS2_j and of the drains DS2_j, respectively, of the first switches S2_j. In each first switch S2_j, the respective drain DS2_j and the respective source SS2_j are aligned with one another in a respective direction (not illustrated) perpendicular to the directions of alignment 520 and 522, and therefore parallel to the axis X. In addition, in the embodiment of Figure 4A also the drain DS1 and the source SS1 of the control switch S1 are aligned with one another in a respective direction (not illustrated) parallel to the axis X.

Furthermore, a drain metallization 530 of the electronic device 1000 (placed, i.e. extending, on the first surface 504a of the second semiconductor body 504 and being, for example, a redistribution layer of metal material such as copper) extends on the drains DS1 and DS2_j of the control switch S1 and of the first switches S2_j, electrically contacting together these drains DS1 and DS2_j and operating as first node 12. In a way not illustrated, the drain metallization 530 is electrically connected, by further conductive vias (not illustrated), to a conductive drain layer 507 (for example, of metal material such as gold or copper), which extends in the solid body 500, for example underneath the layer GND 506.

The first source metallization 532 extends on the source SS1 of the control switch S1 so as to contact electrically, also through the second conductive vias 510, the source SS1 to the layer GND 506.

Moreover, each second source metallization 534_j extends on the source SS2_j of the respective first switch S2_j in electrical contact with said source SS2_j, so as to set, also through the respective first conductive via 508 (or the conductive vias 508 coupled thereto), the respective source SS2_j in electrical contact with the anode LDa_j of the respective laser diode LD_j.

Optionally, the contacts with the conductive vias 508, 510 and with the conductive vias electrically coupled to the drain metallization 530 are obtained by appropriate pads, designated in Figure 4A by the references: 540S1 when they refer to the source SS1 of the control switch S1 (in this case, used to supply a reference voltage to the source SS1, such as the voltage of the reference node GND); 540G1 when they refer to the gate (not illustrated here for simplicity) of the control switch S1; 540D when they refer to the drains DS1 and DS2_j of the control switch S1 and of the first switches S2_j; 540S2_j when they refer to the sources SS2_j of the first switches S2_j (in this case, used to supply the reference voltage to the sources SS2_j); and 540G2_j when they refer to the gates (not illustrated here for simplicity) of the first switches S2_j.

Moreover, optionally, the sources SS2_j (and optionally also the source SS1) are located in a position corresponding to a lateral surface 504c of the second semiconductor body 504, which joins together the first and second surfaces 504a and 504b of the second semiconductor body 504 and which is on top of the lateral surface 500c of the solid body 500. For instance, they face the first surface 504a of the second semiconductor body 504, at an edge of the latter that extends between the first surface 504a and the lateral surface 500c of the second semiconductor body 504.

Figure 4B shows, in the plane XY, a different layout of the second semiconductor body 504, according to a different embodiment.

The above layout is similar to what is illustrated in Figure 4A. However, in Figure 4B the sources SS2_j of the first switches S2_j (in detail, the centroids 520_j) are aligned with one another in a third direction of alignment 540 parallel to the axis X, and the drains DS2_j of the first switches S2_j (in detail, the centroids 522_j) are aligned with one another in a fourth direction of alignment 542 parallel to the axis X. In addition, the source SS1 and the drain DS1 of the control switch S1 are aligned with one another in a respective direction (not illustrated) perpendicular to the directions of alignment 540 and 542, and therefore parallel to the axis Y. In other words, the first switches SS2_j are, fixedly with respect to one another, rotated by 90° in a counterclockwise direction about the axis Z with respect to their position in Figure 4A, and the control switch S1 is rotated by 90° in a counterclockwise direction about the axis Z with respect to its position in Figure 4A.

Optionally, in Figure 4B the control switch S1 and the first switches S2_j have the respective drains DS1 and DS2_j facing one another, so as to simplify mutual electrical coupling of the latter by the drain metallization 530.

Figure 4C shows, in the plane XY, a different layout of the second semiconductor body 504 according to a further embodiment.

This layout is similar to the one illustrated in Figure 4B. However, in Figure 4C the drain DS1 of the control switch S1 laterally surrounds the source SS1 of the control switch S1. For instance, considering a substantially rectangular shape of the source SS1 of the control switch S1, the drain DS1 of the control switch S1 faces three sides SS1a, SS1b, SS1c of the source SS1 (optionally, it also faces at least part of the fourth side SS1d).

Optionally, a portion of the first source metallization 532 overlies, along the axis Z, the first switches S2_j, without being in direct electrical contact with the latter. In particular, this portion of the first source metallization 532 extends in a direction parallel to the first direction of alignment 520 and can be electrically coupled, for example by soldering, to the cathodes LDc_j of the laser diodes LD_j. In greater detail, this portion of the first source metallization 532 extends at respective portions of the first switches S2_j that are comprised between the respective drains DS2_j and the respective sources SS2_j. In this way, it is possible to couple physically and electrically the laser diodes LD_j only to the second semiconductor body 504, and not also to the solid body 500. In fact, the anodes LDa_j of the laser diodes LD_j can be soldered directly to the respective second source metallizations 534_j, and the cathodes LDc_j of the laser diodes LD_j can be soldered to said portion of the first source metallization 532: this further reduces the current paths and therefore the parasitic inductances.

Figure 4D shows, in the plane XY, a different layout of the second semiconductor body 504, according to a further embodiment.

The above layout is similar to what is illustrated in Figure 4A. However, in the embodiment of Figure 4D, some (or even all) of the sources SS2_j of the second switches S2_j are laterally staggered with respect to the laser diodes LD_j. In other words, at least one of the sources SS2_j of the second switches S2_j is not vertically set on top (along the axis Z) of the respective laser diode LD_j to which it is electrically coupled.

This occurs because, in order to be able to generate higher source currents, the second switches S2_j of Figure 4A are designed so as to present larger dimensions (in detail, larger areas of extension in the plane XY) as compared to what is illustrated in Figures 4A-4C. In other words, the maximum relative distance d₁ between the centroids 520_j of the sources SS2_j of first switches S2_j close to one another is greater in Figure 4D than the one illustrated in Figures 3-4C.

However, the maximum relative distance d₂ between the centroids 550 of the anodes LDa_j of the laser diodes LD_j close to one another has a fixed and constant value, in so far as it is generally established by the suppliers of the arrays of laser diodes LD_j, and is not adaptable at will by the end user/customer who connects the laser diodes LD_j to the electronic device 1000.

Consequently, in Figure 4D the maximum relative distance d₁ between the centroids 520_j of the sources SS2_j is greater than the maximum relative distance d₂ between the centroids 550 of the anodes LDa_j of the laser diodes LD_j, and this means that at least some of the sources SS2_j of the second switches S2_j are laterally staggered with respect to the laser diodes LD_j. For instance, this occurs when the source current generated by each of the first switches S2_j must be higher than approximately 10 A.

In Figure 4D, the second source metallizations 534_j can partially extend also over sources SS2_j of first switches S2_j to which they are not directly connected electrically. In other words, in addition to being vertically set on top (along the axis Z) of the sources SS2_j of the respective first switches S2_j to which they are electrically connected, some of the second source metallizations 534_j may also vertically overlie (along the axis Z), in part, sources SS2_j of first switches S2_j to which they are not electrically connected (e.g., they are galvanically insulated therefrom by an oxide layer). In this way, it is possible to contact electrically each of the sources SS2_j of the first switches S2_j with the anodes LDa_j of the respective laser diodes LD_j, even though d₁>d₂.

Unlike what is illustrated in Figure 4A, in Figure 4D the source SS1 and the drain DS1 of the control switch S1 are aligned with one another in a respective direction (not illustrated) parallel to the axis Y. In other words, the control switch S1 is rotated by 90° in a counterclockwise direction about the axis Z with respect to its position in Figure 4A.

Furthermore, optionally one of the first switches S2_j may be arranged, laterally to the control switch S1, in a way similar to what is described for the control switch S1 (and therefore be rotated by 90° in a clockwise direction about the axis Z with respect to the position of the other first switches S2_j).

Optionally, in a way similar to what has been discussed previously with reference to Figure 4C, a portion of the first source metallization 532 overlies, along the axis Z, the first switches S2_j to enable electrical connection of the cathodes LDc_j of the laser diodes LD_j to this portion of the first source metallization 532.

Figure 5 is an example of possible use of the laser lighting module 100 (more in particular, of the electronic device 1000) in a LIDAR application. In particular, Figure 5 shows a vehicle V (e.g., an automobile) comprising the LIDAR apparatus 1.

The LIDAR apparatus 1 defines an emitter path EP and a receiver path RP.

The emitter path EP comprises: the laser lighting module 100, in turn comprising the laser diodes (here designated by LD) and the electronic device 1000 that operates as driving system of the laser diodes LD, as discussed previously; and a LIDAR mirror module 1002 (e.g., an MEMS mirror module), which receives actuation signals A from, and supplies sensing signals S to, a mirror driver (e.g., an ASIC) 1003, for instance with the capacity of lighting a surrounding environment with a vertical laser beam and carrying out in a horizontal direction a scan as desired in order to detect, in a reliable way, a pedestrian within a distance of a few metres.

The receiver path RP comprises: a photodiode module 1004 sensitive to the reflected signal produced as a result of a reflection of the radiation emitted by the emitter path EP on objects lit up by said radiation; and a receiver circuitry 1005 coupled to the photodiode module 1004.

The reference 1006 in Figure 5 designates a controller (a multi-core microcontroller architecture, for example, possibly comprising dedicated FPGA/LIDAR hardware accelerators 1006A) configured to: emit signals for triggering and setting the power of the TPS laser to the electronic device 1000 for laser lighting; exchange driving information DI with the driver 1003 of the LIDAR mirror module 1002; and receive raw data RD from, and send information of trigger and gain setting TGS to, the receiver circuitry 1005 coupled to the photodiode module 1004.

It may be noted that, except for the laser lighting module 100 and more in particular the electronic device 1000, the architecture illustrated in Figure 5 is conventional in the prior art, which renders a more detailed description thereof superfluous. This applies, for example, with reference to the co-ordination of operation of the LIDAR apparatus 1 with operation of the vehicle V (for example, in view of the configuration data received in the controller 1006 and of cloud information of status points as issued by the controller 1006).

From an examination of the characteristics of the invention provided according to the present disclosure, the advantages that it affords are evident.

In particular, the electronic device 1000 enables fast switching of the laser diodes LD_j, with rise and fall times of the respective control signals in the order of 100 ps. Consequently, the laser lighting module 100 enables a controlled generation of the pulses in the range of 1 ns with amplitudes of the current of the range of tens of amps, as well as a facilitated control of the amplitude of the pulse current. Moreover, the use of a common-cathode configuration of the multi-channel laser diodes LD_j prevents spurious activation of the inactive laser diodes LD_j.

Furthermore, the parasitic inductances (in particular, the stray inductance) in the electronic device 100 are reduced thanks to the relative arrangement between the first switches S2_j and the laser diodes LD_j. In particular, the arrangement in Figure 3 of the first and second semiconductor bodies 500, 504 reduces to a minimum the path of the current that leaves the respective first switch S2_j and that biases the laser diode LD_j for activation thereof, and this reduces the corresponding parasitic inductance perceived. In greater detail, the parasitic inductances are reduced (below 0.1 nH, for example) thanks to the presence of a single common switch, such as the control switch S1, and of very short interconnections to the laser diodes LD_j. Instead, conventional circuits comprise an additional capacitor (storage capacitor) in the switching loop, and the corresponding interconnections may present parasitic inductances that exceed 1 nH as a result of the length of the connection relative also to said capacitor. In fact, whereas in traditional circuits biasing of the laser diodes occurs by discharging of the storage capacitor, and therefore the current can depend upon various parameters (values of capacitance, impedance of the storage capacitor plus the laser diode plus the interconnections), which are difficult to control, in the laser lighting module 100 the laser diodes LD_j are driven by a current source by using the inductive energy stored in the resonant tank LC.

In addition, the arrangement in Figure 3 of the first and second semiconductor bodies 500, 504 enables a greater passage of current from the first switches S2_j to the laser diodes LD_j.

The switches, such as the control switch S1 and the first switches S2_j, can be implemented by monolithic common-drain GaN transistors, facilitating integration thereof. The second switches S3_j may, instead, be integrated in a standard IC technology in so far as they are low-power devices that have the function of countering spurious activation of the laser diodes LD_j (to the extent where the spurious currents are limited in amplitude and duration) and of generating an appropriate difference of potential (e.g., comprised between approximately 5 V and approximately 6 V) between the gate and the source SS2_j of the respective first switch S2_j when the latter has to be activated to enable emission of radiation by the respective laser diode LD_j.

Furthermore, the voltage on the control switch S1 is limited to the maximum voltage drop on the laser diodes LD_j, and this contributes to reducing the switching delay due to charging of the parasitic capacitance of the control switch S1.

The electronic device 1000 may be obtained using WLCSP (Wafer Level Chip-Scale Package) technologies, thus minimizing the parasitic inductances and the overall dimensions, and optimizing the thermal performance, the reliability and the overall costs.

For long-range LIDAR applications, the use of laser diodes LD_j of an EEL (Edge-Emitting-Laser) type proves optimal, thanks to their high electro-optical efficiency, their reduced dimensions and costs, and the capacity to produce at output peak levels optical power of hundreds of watts. The fact that the light is emitted laterally (i.e., from the side wall of the laser diode LD_j) simplifies the choice of positioning of the laser diode LD_j in the solid body 500 and guarantees a better interface with possible optical lenses for collimation of the radiation emitted. In addition, EELs present, at working wavelengths of approximately 905 nm, a stability equal to or higher than that of VCSELs (Vertical Cavity Surface Emitting Lasers) at operating temperatures that reach approximately 125°C and that are typical of automotive applications, thus guaranteeing a higher optical output power relative to the latter.

Finally, it is clear that modifications and variations may be made to the what is described and illustrated herein, without thereby departing from the scope of the present invention, as defined in the annexed claims.

In particular, just one laser diode LD_1 may be present, and consequently just one half-bridge S2_1, S3_1.

Furthermore, according to a different embodiment the solid body 500 is formed by a PCB comprising one or more conductive paths (e.g., of metal such as copper), which extend on the first surface 500a. In this case, the laser diodes LD_j, when coupled to the solid body 500, extend on the first surface 500a and are in electrical contact with one of the aforesaid conductive paths, which electrically contacts also the second conductive vias 510 and operates as reference node GND. Moreover, a further conductive path between said conductive paths electrically contacts the drain metallization 530 and operates as first node or line 12. Also electrically coupled (for example, soldered on the first surface 500a) to the solid body 500 are the control circuitry 18, the second switches S3_j, the resonant tank LC and the regulator 16.

In addition, according to a different embodiment, the laser diodes LD_j are coupled only to the second semiconductor body 504 at its first surface 504a, and are not interposed, along the axis Z, between the second semiconductor body 504 and the solid body 500 (which is consequently used only to enable electrical connection of the second semiconductor body 504 with other circuits, such as the control circuitry 18). In this case, the cathodes LDc_j of the laser diodes LD_j are electrically contacted, for example by wire-bonding techniques, to the pad 540D that is connected to the drains DS1 and DS2_j of the control switch S1 and of the first switches S2_j.

The portion of the first source metallization 532 that overlies, along the axis Z, the first switches S2_j to enable electrical connection of the cathodes LDc_j of the laser diodes LD_j to said portion of the first source metallization 532 may be used in any of the embodiments discussed previously.

Likewise, the use of the second source metallizations 534_j vertically overlying (along the axis Z), in part, also sources SS2_j of first switches S2_j, to which they are not electrically connected, can be extended to each of the layouts described previously.

## Claims

1. An electronic device (1000) couplable to a plurality of laser diodes (LD_j), the electronic device (1000) comprising a semiconductor body (504) having a first surface (504a) and including:
- a control switch (S1) having a drain (DS1) electrically coupled to a drain metallization (530) of the electronic device (1000) and having a source (SS1) electrically coupled to a first source metallization (532) of the electronic device (1000), configured to be electrically coupled to cathodes (LDc_j) of the laser diodes (LD_j) ;
- a respective plurality of first switches (S2_j), each first switch (S2_j) having a respective drain (DS2_j) electrically coupled to the drain metallization (530) and having a respective source (SS2_j) electrically coupled to a respective second source metallization (534_j) of the electronic device (1000), configured to be coupled to an anode (LDa_j) of a respective laser diode (LD_j) of the plurality of laser diodes (LD_j),
wherein the drain metallization (530), the first source metallization (532), and the second source metallizations (534_j) extend on the first surface (504a) of the semiconductor body (504), which is configured to face the laser diodes (LD_j),
wherein the second source metallizations (534_j) are aligned with one another in a direction of alignment (520), are superimposed, orthogonally to the direction of alignment (520), to the respective sources (SS2_j) of the first switches (S2_j), and are configured to be aligned, orthogonally to the direction of alignment (520), to the respective laser diodes (LD_j), and
wherein at least one of the sources (SS2_j) of the first switches (S2_j) is configured to be aligned, orthogonally to the direction of alignment (520), to the respective laser diode (LD_j).

2. The electronic device (1000) according to claim 1, further comprising a solid body (500) physically and electrically coupled to the semiconductor body (504) and having a respective first surface (500a) facing the first surface (504a) of the semiconductor body (504),
wherein an electrical-connection element (506) extends in, or over, the solid body (500), is electrically coupled to the first source metallization (532), faces the second source metallizations (534_j), and is configured to be electrically coupled to the cathodes (LDc_j) of the laser diodes (LD_j).

3. The electronic device (1000) according to claim 2, wherein the solid body (500) is formed by a further semiconductor body and has a cavity (502) that extends in the solid body (500) and faces the second source metallizations (534_j), the cavity (502) being configured to house the laser diodes (LD_j), and
wherein the electrical-connection element (506) is formed by a conductive layer.

4. The electronic device (1000) according to claim 3, wherein the solid body (500) further has a second surface (500b) and a lateral surface (500c), the second surface (500b) being opposite to the first surface (500a) of the solid body (500) with respect to the solid body (500), and the lateral surface (500c) joining together the second surface (500b) and the first surface (500a) of the solid body (500),
wherein the cavity (502) further faces the lateral surface (500c).

5. The electronic device (1000) according to claim 2, wherein the solid body (500) is formed by a PCB, and
wherein the electrical-connection element (506) is formed by a conductive path on the first surface (500a) of the solid body (500).

6. The electronic device (1000) according to any one of the preceding claims, wherein the source (SS2_j) of each first switch (S2_j) is configured to be superimposed, orthogonally to the direction of alignment (520), to the anode (LDa_j) of the respective laser diode (LD_j) with which it is in electrical contact.

7. The electronic device (1000) according to claim 6, wherein a centroid (520_j), measured parallelly to the first surface (504a) of the semiconductor body (504), of the source (SS2_j) of each first switch (S2_j) is configured to be superimposed, orthogonally to the first surface (504a) of the semiconductor body (504), to a centroid (550), measured parallelly to the first surface (500a) of the solid body (500), of the anode (LDa_j) of the respective laser diode (LD_j) .

8. The electronic device (1000) according to any one of the preceding claims, wherein the first switches (S2_j) are arranged in an array, and the sources (SS2_j) of the first switches (S2_j) are aligned with one another in the direction of alignment (520).

9. The electronic device (1000) according to claims 7 and 8, wherein the centroids (520_j) of the sources (SS2_j) of first switches (S2_j) immediately consecutive to one another in said array have a maximum relative distance (d₁) between them of less than 500 µm.

10. The electronic device (1000) according to any one of the preceding claims, wherein the sources (SS2_j) of the first switches (S2_j) are physically and electrically couplable to the respective anodes (LDa_j) of the laser diodes (LD_j) through conductive vias (508)extending orthogonally to the first surface (504a) of the semiconductor body (504) and having a maximum length, measured orthogonally to the first surface (504a) of the semiconductor body (504), of less than 500 µm.

11. The electronic device (1000) according to any one of the preceding claims, wherein the control switch (S1) and the first switches (S2_j) are GaN devices.

12. The electronic device (1000) according to any one of the preceding claims, wherein at least one of the second source metallizations (534_j) is further superimposed, orthogonally to the direction of alignment (520), to one or more of the sources (SS2_j) of the first switches (S2_j) from which said at least one second source metallization (534_j) is electrically decoupled.

13. The electronic device (1000) according to any one of the preceding claims, wherein a portion of the first source metallization (532) extends parallelly to the direction of alignment (520) and is configured to be electrically coupled, through soldering, to the cathodes (LDc_j) of the laser diodes (LD_j).

14. A laser-driving module comprising:
- an electronic device (1000) according to any one of claims 1-13, wherein the drain metallization (530) forms a first node (12), the first source metallization (532) forms a reference node (GND), and each of the second source metallizations (534_j) forms a respective driving node (12ⱼ);
- a resonant circuit (LC), which comprises a series connection of an inductance (Lr) and a capacitance (Cr) having an intermediate node (14) between them, the resonant circuit (LC) being coupled between the first node (12) and the reference node (GND);
- a charging circuitry (16) coupled between a supply node (VCC) and the intermediate node (14) in the resonant circuit (LC) for charging the capacitance (Cr) in the resonant circuit (LC), and
- a driving circuitry (18, 182_j, 201, 202, 203) for driving the control switch (S1) and of the first switches (S2_j), the driving circuitry (18, 182_j, 201, 202, 203) being configured to repeat cycles of generation of the pulses comprising:
closing the control switch (S1), the resonant circuit (LC) being therefore enabled to oscillate with an increasing current that flows in the inductance (Lr) of the resonant circuit (LC),
in response to the fact that the current that flows in the inductance (Lr) of the resonant circuit (LC) reaches a threshold value, opening the control switch (S1), and, as a result of the fact that one of the first switches (S2_j) is closed for a respective pulse-duration time (Ton_S2_j), switching the current that flows in the inductance (Lr) of the resonant circuit (LC) towards one of the first switches (S2_j) and the respective driving node (12ⱼ), and
opening the one of the first switches (S2_j) when said respective pulse-duration time (Ton_S2_j) elapses.

15. The laser-driving module according to claim 14, wherein each first switch (S2_j) has associated to it a respective second switch (S3_j) coupled between the respective driving node (12ⱼ) and the reference node (GND), and
wherein the driving circuitry (18, 182_j, 201, 202, 203) is configured to close selectively said second switch (S3_j) in order to couple the respective driving node (12ⱼ) to the reference node (GND).

16. A laser lighting module (100) comprising a laser-driving module, according to claim 14 or claim 15, and said laser diodes (LD_j).

17. The laser lighting module (100) according to claim 16, wherein the laser diodes (LD_j) are edge-emitting lasers.

18. A LIDAR apparatus (1) comprising a laser lighting module (100) according to claim 16 or claim 17.

## Patentansprüche

1. Elektronische Vorrichtung (1000), die mit einer Vielzahl von Laserdioden (LD_j) gekoppelt werden kann, wobei die elektronische Vorrichtung (1000) einen Halbleiterkörper (504) umfasst, der eine erste Oberfläche (504a) aufweist und Folgendes einschließt:
- einen Steuerschalter (S1), der einen Drain (DS1) aufweist, der elektrisch mit einer Drain-Metallisierung (530) der elektronischen Vorrichtung (1000) gekoppelt ist, und der eine Source (SS1) aufweist, die elektrisch mit einer ersten Source-Metallisierung (532) der elektronischen Vorrichtung (1000) gekoppelt ist und so konfiguriert ist, dass sie elektrisch mit Kathoden (LDc_j) der Laserdioden (LD_j) gekoppelt ist;
- eine jeweilige Vielzahl von ersten Schaltern (S2_j), wobei jeder erste Schalter (S2_j) ein jeweiliges Drain (DS2_j) aufweist, das elektrisch mit der Drain-Metallisierung (530) gekoppelt ist, und eine jeweilige Source (SS2_j) aufweist, die elektrisch mit einer jeweiligen zweiten Source-Metallisierung (534_j) der elektronischen Vorrichtung (1000) gekoppelt ist, konfiguriert, um mit einer Anode (LDa_j) einer jeweiligen Laserdiode (LD_j) der Vielzahl von Laserdioden (LD_j) gekoppelt zu werden,
wobei die Drain-Metallisierung (530), die erste Source-Metallisierung (532) und die zweite Source-Metallisierung (534_j) sich auf der ersten Oberfläche (504a) des Halbleiterkörpers (504) erstrecken, die so konfiguriert ist, dass sie den Laserdioden (LD_j) zugewandt ist,
wobei die zweiten Source-Metallisierungen (534_j) in einer Ausrichtungsrichtung (520) zueinander ausgerichtet sind, orthogonal zur Ausrichtungsrichtung (520) den jeweiligen Sources (SS2_j) der ersten Schalter (S2_j) überlagert sind und so konfiguriert sind, dass sie orthogonal zur Ausrichtungsrichtung (520) auf die jeweiligen Laserdioden (LD_j) ausgerichtet sind, und
wobei mindestens eine der Sources (SS2_j) der ersten Schalter (S2_j) so konfiguriert ist, dass sie orthogonal zur Ausrichtungsrichtung (520) auf die jeweilige Laserdiode (LD_j) ausgerichtet ist.

2. Elektronische Vorrichtung (1000) nach Anspruch 1, ferner umfassend einen festen Körper (500), der physisch und elektrisch mit dem Halbleiterkörper (504) gekoppelt ist und eine entsprechende erste Oberfläche (500a) aufweist, die der ersten Oberfläche (504a) des Halbleiterkörpers (504) gegenüberliegt,
wobei sich ein elektrisches Verbindungselement (506) in oder über den festen Körper (500) erstreckt, elektrisch mit der ersten Source-Metallisierung (532) verbunden ist, den zweiten Source-Metallisierungen (534_j) gegenüberliegt und so konfiguriert ist, dass es elektrisch mit den Kathoden (LDc_j) der Laserdioden (LD_j) verbunden ist.

3. Elektronische Vorrichtung (1000) nach Anspruch 2, wobei der feste Körper (500) durch einen weiteren Halbleiterkörper gebildet wird und einen Hohlraum (502) aufweist, der sich in dem festen Körper (500) erstreckt und den zweiten Source-Metallisierungen (534_j) zugewandt ist, wobei der Hohlraum (502) konfiguriert ist, um die Laserdioden (LD_j) aufzunehmen, und
wobei das elektrische Verbindungselement (506) durch eine leitende Schicht gebildet wird.

4. Elektronische Vorrichtung (1000) nach Anspruch 3, wobei der feste Körper (500) ferner eine zweite Oberfläche (500b) und eine seitliche Oberfläche (500c) aufweist, wobei die zweite Oberfläche (500b) der ersten Oberfläche (500a) des festen Körpers (500) in Bezug auf den festen Körper (500) gegenüberliegt und die seitliche Oberfläche (500c) die zweite Oberfläche (500b) und die erste Oberfläche (500a) des festen Körpers (500) miteinander verbindet,
wobei der Hohlraum (502) ferner der seitlichen Oberfläche (500c) zugewandt ist.

5. Elektronische Vorrichtung (1000) nach Anspruch 2, wobei der feste Körper (500) durch eine PCB gebildet wird, und wobei das elektrische Verbindungselement (506) durch einen leitenden Pfad auf der ersten Oberfläche (500a) des festen Körpers (500) gebildet wird.

6. Elektronische Vorrichtung (1000) nach einem der vorstehenden Ansprüche, wobei die Source (SS2_j) jedes ersten Schalters (S2_j) so konfiguriert ist, dass sie der Anode (LDa_j) der jeweiligen Laserdiode (LD_j), mit der sie in elektrischem Kontakt steht, orthogonal zur Ausrichtungsrichtung (520) überlagert ist.

7. Elektronische Vorrichtung (1000) nach Anspruch 6, wobei ein parallel zur ersten Oberfläche (504a) des Halbleiterkörpers (504) gemessener Schwerpunkt (520_j) der Source (SS2_j) jedes ersten Schalters (S2_j) konfiguriert ist, um überlagert zu werden, orthogonal zu der ersten Oberfläche (504a) des Halbleiterkörpers (504) einem Schwerpunkt (550), gemessen parallel zu der ersten Oberfläche (500a) des festen Körpers (500), der Anode (LDa_j) der jeweiligen Laserdiode (LD_j) überlagert wird.

8. Elektronische Vorrichtung (1000) nach einem der vorstehenden Ansprüche, wobei die ersten Schalter (S2_j) in einem Array angeordnet sind und die Sources (SS2_j) der ersten Schalter (S2_j) in Ausrichtungsrichtung (520) zueinander ausgerichtet sind.

9. Elektronische Vorrichtung (1000) nach den Ansprüchen 7 und 8, wobei die Schwerpunkte (520_j) der Sources (SS2_j) der ersten Schalter (S2_j), die in dem Array unmittelbar aufeinander folgen, einen maximalen relativen Abstand (d₁) von weniger als 500 µm aufweisen.

10. Elektronische Vorrichtung (1000) nach einem der vorstehenden Ansprüche, wobei die Sources (SS2_j) der ersten Schalter (S2_j) mit den jeweiligen Anoden (LDa_j) der Laserdioden (LD_j) über leitende Vias (508) physikalisch und elektrisch koppelbar sind, die sich orthogonal zur ersten Oberfläche (504a) des Halbleiterkörpers (504) erstrecken und eine maximale Länge, gemessen orthogonal zur ersten Oberfläche (504a) des Halbleiterkörpers (504), von weniger als 500 µm aufweisen.

11. Elektronische Vorrichtung (1000) nach einem der vorstehenden Ansprüche, wobei der Steuerschalter (S1) und die ersten Schalter (S2_j) GaN-Vorrichtungen sind.

12. Elektronische Vorrichtung (1000) nach einem der vorstehenden Ansprüche, wobei mindestens eine der zweiten Source-Metallisierungen (534_j) ferner orthogonal zur Ausrichtungsrichtung (520) einer oder mehreren der Sources (SS2_j) der ersten Schalter (S2_j) überlagert ist, von denen die mindestens eine zweite Source-Metallisierung (534_j) elektrisch entkoppelt ist.

13. Elektronische Vorrichtung (1000) nach einem der vorstehenden Ansprüche, wobei sich ein Abschnitt der ersten Source-Metallisierung (532) parallel zur Ausrichtungsrichtung (520) erstreckt und so konfiguriert ist, dass er durch Löten mit den Kathoden (LDc_j) der Laserdioden (LD_j) elektrisch gekoppelt wird.

14. Laserantriebsmodul, umfassend:
- eine elektronische Vorrichtung (1000) nach einem der Ansprüche 1-13, wobei die Drain-Metallisierung (530) einen ersten Knoten (12) bildet, die erste Source-Metallisierung (532) einen Referenzknoten (GND) bildet und jede der zweiten Source-Metallisierungen (534_j) einen jeweiligen Antriebsknoten (12ⱼ) bildet;
- eine Resonanzschaltung (LC), die eine Reihenschaltung einer Induktivität (Lr) und einer Kapazität (Cr) mit einem Zwischenknoten (14) dazwischen aufweist, wobei die Resonanzschaltung (LC) zwischen dem ersten Knoten (12) und dem Bezugsknoten (GND) gekoppelt ist;
- eine Ladeschaltlogik (16), die zwischen einen Zuführungsknoten (VCC) und den Zwischenknoten (14) in der Resonanzschaltung (LC) gekoppelt ist, um die Kapazität (Cr) in der Resonanzschaltung (LC) zu laden, und
- eine Treiberschaltlogik (18, 182_j, 201, 202, 203) zum Ansteuern des Steuerschalters (S1) und der ersten Schalter (S2_j), die Treiberschaltlogik (18, 182_j, 201, 202, 203) ist zur Wiederholung von Zyklen der Erzeugung der Impulse konfiguriert, umfassend:
Schließen des Steuerschalters (S1), wodurch die Resonanzschaltung (LC) in die Lage versetzt wird, mit einer Steigerung des Stroms zu schwingen, der in der Induktivität (Lr) der Resonanzschaltung (LC) fließt,
als Reaktion darauf, dass der in der Induktivität (Lr) der Resonanzschaltung (LC) fließende Strom einen Schwellenwert erreicht, Öffnen des Steuerschalters (S1), und als Folge davon, dass einer der ersten Schalter (S2_j) für eine jeweilige Impulsdauerzeit (Ton_S2_j) geschlossen ist, Schalten des in der Induktivität (Lr) der Resonanzschaltung (LC) fließenden Stroms in Richtung auf einen der ersten Schalter (S2_j) und den jeweiligen Antriebsknoten (12ⱼ), und
Öffnen des einen der ersten Schalter (S2_j), wenn die entsprechende Impulsdauerzeit (Ton_S2_j) abläuft.

15. Laserantriebsmodul nach Anspruch 14, wobei jedem ersten Schalter (S2_j) ein entsprechender zweiter Schalter (S3_j) zugeordnet ist, der zwischen dem entsprechenden Antriebsknoten (12ⱼ) und dem Referenzknoten (GND) gekoppelt ist, und
wobei die Antriebsschaltlogik (18, 182_j, 201, 202, 203) konfiguriert ist, um den zweiten Schalter (S3_j) selektiv zu schließen, um den jeweiligen Antriebsknoten (12ⱼ) mit dem Referenzknoten (GND) zu koppeln.

16. Laserbeleuchtungsmodul (100), umfassend ein Laserantriebsmodul nach Anspruch 14 oder 15 und die Laserdioden (LD_j).

17. Laserbeleuchtungsmodul (100) nach Anspruch 16, wobei die Laserdioden (LD_j) kantenemittierende Laser sind.

18. LIDAR-Gerät (1), umfassend ein Laserbeleuchtungsmodul (100) nach Anspruch 16 oder 17.

## Revendications

1. Dispositif électronique (1000) pouvant être couplé à une pluralité de diodes laser (LD_j), le dispositif électronique (1000) comprenant un corps semiconducteur (504) ayant une première surface (504a) et comportant :
- un interrupteur de commande (S1) ayant un drain (DS1) couplé électriquement à une métallisation de drain (530) du dispositif électronique (1000) et ayant une source (SS1) couplée électriquement à une première métallisation de source (532) du dispositif électronique (1000), configurée pour être couplée électriquement à des cathodes (LDc_j) des diodes laser (LD_j) ;
- une pluralité respective de premiers interrupteurs (S2_j), chaque premier interrupteur (S2_j) ayant un drain respectif (DS2_j) couplé électriquement à la métallisation de drain (530) et ayant une source respective (SS2_j) couplée électriquement à une deuxième métallisation de source respective (534_j) du dispositif électronique (1000), configurée pour être couplée à une anode (LDa_j) d'une diode laser respective (LD_j) de la pluralité de diodes laser (LD_j),
dans lequel la métallisation de drain (530), la première métallisation de source (532) et la deuxième métallisation de source respective (534_j) s'étendent sur la première surface (504a) du corps semiconducteur (504), qui est configurée pour faire face aux diodes laser (LD_j),
dans lequel les deuxièmes métallisations de source (534_j) sont alignées entre elles dans une direction d'alignement (520), et superposées, orthogonalement à la direction d'alignement (520), aux sources respectives (SS2_j) des premiers interrupteurs (S2_j), et sont configurées pour être alignées, orthogonalement à la direction d'alignement (520), avec les diodes laser respectives (LD_j), et
dans lequel au moins l'une des sources (SS2_j) des premiers interrupteurs (S2_j) est configurée pour être alignée, orthogonalement à la direction d'alignement (520), avec la diode laser respective (LD_j).

2. Dispositif électronique (1000) selon la revendication 1, comprenant en outre un corps plein (500) couplé physiquement et électriquement au corps semiconducteur (504) et ayant une première surface respective (500a) faisant face à la première surface (504a) du corps semiconducteur (504),
dans lequel un élément de connexion électrique (506) s'étend dans, ou sur, le corps plein (500), est couplé électriquement à la première métallisation de source (532), fait face aux deuxièmes métallisations de source (534_j), et est configuré pour être couplé électriquement aux cathodes (LDc_j) des diodes laser (LD_j).

3. Dispositif électronique (1000) selon la revendication 2, dans lequel le corps plein (500) est formé par un autre corps semiconducteur et comporte une cavité (502) qui s'étend dans le corps plein (500) et qui fait face aux deuxièmes métallisations de source (534_j), la cavité (502) étant configurée pour recevoir les diodes laser (LD_j), et
dans lequel l'élément de connexion électrique (506) est formé par une couche conductrice.

4. Dispositif électronique (1000) selon la revendication 3, dans lequel le corps plein (500) comporte en outre une deuxième surface (500b) et une surface latérale (500c), la deuxième surface (500b) étant opposée à la première surface (500a) du corps plein (500) par rapport au corps plein (500), et la surface latérale (500c) reliant ensemble la deuxième surface (500b) et la première surface (500a) du corps plein (500),
dans lequel la cavité (502) fait face en outre à la surface latérale (500c).

5. Dispositif électronique (1000) selon la revendication 2, dans lequel le corps plein (500) est formé par une carte de circuit imprimé, et
dans lequel l'élément de connexion électrique (506) est formé par un chemin conducteur sur la première surface (500a) du corps plein (500).

6. Dispositif électronique (1000) selon l'une quelconque des revendications précédentes, dans lequel la source (SS2_j) de chaque premier interrupteur (S2_j) est configurée pour être superposée, orthogonalement à la direction d'alignement (520), à l'anode (LDa_j) de la diode laser respective (LD_j) avec laquelle elle est en contact électrique.

7. Dispositif électronique (1000) selon la revendication 6, dans lequel un centre de gravité (520_j), mesuré parallèlement à la première surface (504a) du corps semiconducteur (504), de la source (SS2_j) de chaque premier interrupteur (S2_j) est configuré pour être superposé, orthogonalement à la première surface (504a) du corps semiconducteur (504), à un centre de gravité (550), mesuré parallèlement à la première surface (500a) du corps plein (500), de l'anode (LDa_j) de la diode laser respective (LD_j).

8. Dispositif électronique (1000) selon l'une quelconque des revendications précédentes, dans lequel les premiers interrupteurs (S2_j) sont disposés en matrice, et les sources (SS2_j) des premiers interrupteurs (S2_j) sont alignées entre elles dans la direction d'alignement (520).

9. Dispositif électronique (1000) selon les revendications 7 et 8, dans lequel les centres de gravité (520_j) des sources (SS2_j) de premiers interrupteurs (S2_j) qui se suivent immédiatement dans ladite matrice ont une distance relative maximale (d₁) entre eux qui est inférieure à 500 µm.

10. Dispositif électronique (1000) selon l'une quelconque des revendications précédentes, dans lequel les sources (SS2_j) des premiers interrupteurs (S2_j) peuvent être couplées physiquement et électriquement aux anodes respectives (LDa_j) des diodes laser (LD_j) par l'intermédiaire de trous d'interconnexion conducteurs (508) s'étendant orthogonalement à la première surface (504a) du corps semiconducteur (504) et ayant une longueur maximale, mesurée orthogonalement à la première surface (504a) du corps semiconducteur (504), qui est inférieure à 500 µm.

11. Dispositif électronique (1000) selon l'une quelconque des revendications précédentes, dans lequel l'interrupteur de commande (S1) et les premiers interrupteurs (S2_j) sont des dispositifs au GaN.

12. Dispositif électronique (1000) selon l'une quelconque des revendications précédentes, dans lequel au moins l'une des deuxièmes métallisations de source (534_j) est en outre superposée, orthogonalement à la direction d'alignement (520), à l'une ou plusieurs des sources (SS2_j) des premiers interrupteurs (S2_j) desquels ladite au moins une deuxième métallisation de source (534_j) est électriquement découplée.

13. Dispositif électronique (1000) selon l'une quelconque des revendications précédentes, dans lequel une partie de la première métallisation de source (532) s'étend parallèlement à la direction d'alignement (520) et est configurée pour être couplée électriquement, par brasage, aux cathodes (LDc_j) des diodes laser (LD_j).

14. Module de pilotage de laser comprenant :
- un dispositif électronique (1000) selon l'une quelconque des revendications 1 à 13, dans lequel la métallisation de drain (530) forme un premier nœud (12), la première métallisation de source (532) forme un nœud de référence (GND), et chacune des deuxièmes métallisations de source (534_j) forme un nœud de pilotage respectif (12ⱼ) ;
- un circuit résonnant (LC), qui comprend une connexion série d'une inductance (Lr) et d'une capacité (Cr) avec un nœud intermédiaire (14) entre elles, le circuit résonnant (LC) étant couplé entre le premier nœud (12) et le nœud de référence (GND) ;
- un montage de charge (16) couplé entre un nœud d'alimentation (VCC) et le nœud intermédiaire (14) dans le circuit résonnant (LC) pour charger la capacité (Cr) dans le circuit résonnant (LC), et
- un montage de pilotage (18, 182_j, 201, 202, 203) pour piloter l'interrupteur de commande (S1) et les premiers interrupteurs (S2_j), le montage de pilotage (18, 182_j, 201, 202, 203) étant configuré pour répéter des cycles de production des impulsions comprenant les opérations suivantes :
fermer l'interrupteur de commande (S1), le circuit résonnant (LC) étant par conséquent activé pour osciller avec un courant croissant qui circule dans l'inductance (Lr) du circuit résonnant (LC),
en réponse au fait que le courant qui circule dans l'inductance (Lr) du circuit résonnant (LC) atteint une valeur de seuil, ouvrir l'interrupteur de commande (S1) et, si l'un des premiers interrupteurs (S2_j) est fermé pendant une durée d'impulsion respective (Ton_S2_j), faire commuter le courant qui circule dans l'inductance (Lr) du circuit résonnant (LC) vers l'un des premiers interrupteurs (S2_j) et le nœud de pilotage respectif (12ⱼ), et
ouvrir ledit un des premiers interrupteurs (S2_j) lorsque ladite durée d'impulsion respective (Ton_S2_j) s'est écoulée.

15. Module de pilotage de laser selon la revendication 14, dans lequel chaque premier interrupteur (S2_j) a un deuxième interrupteur respectif (S3_j) qui lui est associé, couplé entre le nœud de pilotage respectif (12ⱼ) et le nœud de référence (GND), et
dans lequel le montage de pilotage (18, 182_j, 201, 202, 203) est configuré pour fermer sélectivement ledit deuxième interrupteur (S3_j) afin de coupler le nœud de pilotage respectif (12ⱼ) au nœud de référence (GND).

16. Module d'éclairage laser (100) comprenant un module de pilotage de laser selon la revendication 14 ou 15, et lesdites diodes laser (LD_j).

17. Module d'éclairage laser (100) selon la revendication 16, dans lequel les diodes laser (LD_j) sont des lasers à émission latérale.

18. Appareil lidar (1) comprenant un module d'éclairage laser (100) selon la revendication 16 ou 17.
